(19) **Europäisches Patentamt / European Patent Office / Office européen des brevets**

(11) **EP 2 766 739 B1**

(12) **FASCICULE DE BREVET EUROPEEN**

(45) Date de publication et mention de la délivrance du brevet:
**21.06.2017 Bulletin 2017/25**

(21) Numéro de dépôt: **12780241.1**

(22) Date de dépôt: **11.10.2012**

(51) Int Cl.:
***G01R 31/12*** *(2006.01)*

(86) Numéro de dépôt international:
**PCT/FR2012/052317**

(87) Numéro de publication internationale:
**WO 2013/054052 (18.04.2013 Gazette 2013/16)**

(54) **PROCÉDÉ ET DISPOSITIF DE DÉTECTION D'UN DÉFAUT D'ISOLEMENT DANS UN RÉSEAU ÉLECTRIQUE BASSE TENSION**

**VERFAHREN UND GERÄT ZUR ERFASSUNG VON ISOLATIONSFEHLERN IN EINEM NIEDERSPANNUNGS-NETZWERK**

**PROCEDURE AND DEVICE FOR DETECTING INSULATION FAULTS IN A LOW VOLTAGE NETWORK**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.10.2011 FR 1159235**

(43) Date de publication de la demande:
**20.08.2014 Bulletin 2014/34**

(73) Titulaires:
• **Gaeta, Michel**
  **83160 La Valette du Var (FR)**
• **Roquelaure, Jean-marc**
  **13100 Aix en Provence (FR)**

(72) Inventeurs:
• **Gaeta, Michel**
  **83160 La Valette du Var (FR)**
• **Roquelaure, Jean-marc**
  **13100 Aix en Provence (FR)**

(74) Mandataire: **Marchand, André et al**
**OMNIPAT**
**24 Place des Martyrs de la Résistance**
**13100 Aix-en-Provence (FR)**

(56) Documents cités:
**EP-A2- 0 639 879      JP-A- 2005 156 452**
**US-A- 5 835 321      US-A1- 2006 214 668**

**Description**

La présente invention concerne un dispositif et un procédé de détection, dans un réseau électrique véhiculant une tension alternative basse tension, d'un défaut d'isolement se traduisant par l'apparition de signaux de décharge partielle. La présente invention concerne notamment un dispositif et un procédé de détection d'un amorçage d'incendie.

Il est connu qu'un amorçage d'incendie dans une ligne électrique se traduit par l'apparition préalable de décharges partielles qui sont le signe d'un défaut d'isolation de la ligne électrique. Ces décharges partielles conduisent à l'inflammation de matériaux environnants sans que les dispositifs de sécurité classiques ne puissent entrer en action. Un disjoncteur différentiel est en effet inopérant à ce stade du défaut car aucune fuite à la terre n'est encore détectable. De même, un disjoncteur de puissance n'est pas affecté car les puissances mises en jeu restent modestes bien que les énergies d'amorçage soient élevées.

De telles décharges partielles créent des perturbations électromagnétiques impulsionnelles, appelées signaux de décharge partielle, qui peuvent être détectées. La détection des signaux de décharge partielle permet la mise en oeuvre de contre-mesures permettant d'éviter l'inflammation des matériaux environnants.

Des procédés ou dispositifs de détection de signaux de décharge partielle ont déjà été proposés. Le brevet US 6,172,862 décrit un système de détection comprenant un capteur capable de mesurer des décharges de l'ordre de quelques picocoulombs et des moyens pour les comparer à un seuil de référence. La demande de brevet US 2010/0073008 décrit un système de détection comprenant un filtre configuré pour transmettre à un amplificateur différentiel des signaux de décharge partielle haute fréquence et filtrer la tension basse fréquence du réseau. La demande de brevet US 2008/0309351 décrit un dispositif de détection comprenant une première branche présentant une première impédance pour des signaux de décharge partielle apparaissant dans la tension réseau, et une seconde branche présentant une seconde impédance inférieure à la première pour les signaux de décharge partielle apparaissant dans la tension réseau, de sorte que les signaux de décharge partielle sont transmis préférentiellement dans la seconde branche. Le brevet US 5,835,321 décrit un dispositif de détection comprenant un filtre passe bande et configuré pour détecter un courant de décharge partielle dans une bande de fréquence déterminée.

Par ailleurs, EP 0 639 879 A2 enseigne une détection d'arc électrique par détection de changements du cycle d'un courant alternatif. Le courant alternatif est échantillonné avec un filtre coupe-bande au cours de chacune d'une pluralité de cycles du courant alternatif, pour fournir une pluralité de courants In, m, où "n" est la phase et "m" le cycle. Des valeurs absolues de signaux de différence de courant sont accumulées dans un sommateur synchrone au cours des m cycles. Un signal indicatif de la présence d'un arc est généré en réponse à des conditions données et compte tenu des combinaisons de conditions du courant cumulé absolue des signaux de différence.

JP 2005 156452 se rapporte à des dispositifs d'isolation haute tension à gaz ou "GIS" (Gas Insulated Switchgear) utilisant un gaz de type SF6 comme moyen d'isolation de deux éléments soumis à une haute tension, et vise à discriminer plusieurs types de décharges partielles, internes et externes, au moyen d'un capteur ou d'une antenne.

Il existe donc divers méthodes connues pour la détection de signaux de décharge partielle, avec ou sans filtrage, par détection de courant ou de tension, à seuil variable, etc. Ces diverses méthodes visent généralement à distinguer les "faux" signaux de décharge partielle, qui ne sont pas liés à un défaut d'isolement, des "vrais" signaux de décharge partielle, afin d'éviter les fausses alertes. En effet, divers signaux parasites pouvant apparaître sur le réseau ne sont pas dus à un défaut d'isolation entraînant un amorçage d'incendie ou autre dysfonctionnement à détecter, et sont seulement provoqués par des appareillages ou des éclairages connectés au réseau, tels des éclairages au néon. Les méthodes basées sur une analyse en fréquence des signaux de décharge partielle et/ou sur une détermination fine de seuils de détection s'avèrent parfois inefficaces pour la différentiation des vrais et des faux signaux de décharge partielle.

Il peut donc être souhaité de prévoir un procédé et un dispositif de détection d'un défaut d'isolement qui offre une meilleure fiabilité de détection.

Des modes de réalisation de l'invention concernent un dispositif de détection, dans un réseau électrique véhiculant une tension alternative basse tension (Vac), d'un défaut d'isolement entre un fil de phase (P) et un fil de neutre (N) se traduisant par l'apparition de signaux de décharge partielle (PDS), comprenant des moyens de détection de signaux de décharge partielle par analyse de la tension (Vac) ou du courant véhiculé par le réseau électrique, et des moyens pour associer à chaque signal de décharge partielle détecté un paramètre indicatif de la position du signal de décharge partielle sur la courbe de la tension alternative, et rechercher s'il existe, entre plusieurs signaux de décharge partielle détectés pendant des cycles de variation différents de la tension alternative, au moins une corrélation indicative d'un défaut d'isolement, en tenant compte du paramètre indicatif de la position du signal de décharge partielle sur la courbe de la tension alternative.

Selon un mode de réalisation, le dispositif est configuré pour définir comme paramètre indicatif de la position d'un signal de décharge partielle sur la courbe de la tension alternative, des groupes de valeurs de tension de la tension alternative, et associer à chaque signal de décharge détecté un groupe de valeurs de tension de la tension alternative.

Selon un mode de réalisation, le dispositif est configuré pour identifier chaque groupe de valeurs de tension

# EP 2 766 739 B1

de la tension alternative au moyen d'un créneau temporel représentant une fraction de la période de la tension alternative.

Selon un mode de réalisation, le dispositif est configuré pour détecter un défaut d'isolement lorsqu'un premier nombre de signaux de décharge partielle est détecté pendant un premier nombre de cycles successifs de la tension alternative en relation avec un même groupe de valeurs de tension de la tension alternative.

Selon un mode de réalisation, le dispositif est configuré pour détecter un défaut d'isolement lorsque un premier nombre de signaux de décharge partielle est détecté pendant un premier nombre de cycles successifs de la tension alternative en relation avec un premier groupe de valeurs de tension de la tension alternative, et un second nombre de signaux de décharge partielle est ensuite détecté pendant un second nombre de cycles successifs de la tension alternative en relation avec un second groupe de valeurs de tension de la tension alternative comprenant des valeurs de tension inférieures aux valeurs du premier groupe.

Selon un mode de réalisation, les moyens de détection de signaux de décharge partielle comprennent un circuit d'acquisition pour extraire de la tension alternative un signal de référence susceptible de contenir des signaux de décharge partielle, un circuit de traitement du signal de référence, configuré pour, pour chaque groupe de valeurs de tension de la tension alternative: déterminer une valeur actuelle de l'amplitude du signal de référence, calculer une valeur moyenne de l'amplitude du signal de référence d'enveloppe à partir de la valeur actuelle de l'amplitude du signal de référence et de M-1 valeurs précédentes de l'amplitude du signal de référence mesurées au cours de cycles précédents de la tension alternative en relation avec le groupe de valeurs de tension de la tension alternative considéré, déterminer un seuil de détection qui est fonction de la valeur moyenne de l'amplitude du signal de référence, et détecter un signal de décharge partielle si la valeur actuelle de l'amplitude du signal de référence est supérieure au seuil de détection.

Selon un mode de réalisation, le circuit d'acquisition comprend un circuit intégrateur recevant en entrée un signal filtré extrait de la tension alternative et fournissant le signal de référence.

Selon un mode de réalisation, le circuit de détection est configuré pour numériser le signal de référence pour chaque groupe de valeurs de tension de la tension alternative, et fournir un échantillon numérique représentatif de l'amplitude du signal de référence en relation avec le groupe de valeurs de tension de la tension alternative considéré.

Selon un mode de réalisation, le circuit de détection est configuré pour calculer la valeur moyenne de l'amplitude du signal de référence à partir d'un groupe de M échantillons numériques comprenant l'échantillon numérique représentatif de l'amplitude actuelle du signal de référence et M-1 échantillons numériques représentatifs de l'amplitude du signal de référence au cours de cycles précédents de la tension alternative en relation avec le même groupe de valeurs de tension de la tension alternative.

Selon un mode de réalisation, le circuit de détection est configuré pour générer des mots binaires de N bits dans lesquels chaque bit est associé à un groupe de valeurs de tension de la tension alternative, et présente une première valeur si un signal de décharge partielle a été détecté en relation avec le groupe de valeurs de tension de la tension alternative considéré et une second valeur logique si un signal de décharge partielle n'a pas été détecté en relation avec le groupe de valeurs de tension considéré.

Des modes de réalisation de l'invention concernent également un procédé de détection d'un défaut d'isolement entre un fil de phase (P) et un fil de neutre (N) dans un réseau électrique véhiculant une tension alternative (Vac) basse tension, comprenant des étapes de détection de signaux de décharge partielle par analyse de la tension (Vac) ou du courant véhiculé par le réseau électrique, et des étapes consistant à associer à chaque signal de décharge partielle détecté un paramètre indicatif de la position du signal de décharge partielle sur la courbe de la tension alternative, et rechercher s'il existe, entre plusieurs signaux de décharge partielle détectés pendant des cycles de variation différents de la tension alternative, au moins une corrélation indicative d'un défaut d'isolement, en tenant compte du paramètre indicatif de la position du signal de décharge partielle sur la courbe de la tension alternative.

Selon un mode de réalisation, le procédé comprend les étapes consistant à définir comme paramètre indicatif de la position d'un signal de décharge partielle sur la courbe de la tension alternative, des groupes de valeurs de tension de la tension alternative, et associer à chaque signal de décharge détecté un groupe de valeurs de tension de la tension alternative.

Selon un mode de réalisation, chaque groupe de valeurs de tension de la tension alternative est identifié au moyen d'un créneau temporel représentant une fraction de la période de la tension alternative.

Selon un mode de réalisation, un défaut d'isolement est détecté lorsqu'un premier nombre de signaux de décharge partielle est détecté pendant un premier nombre de cycles successifs de la tension alternative en relation avec le même groupe de valeurs de tension de la tension alternative.

Selon un mode de réalisation, un défaut d'isolement est détecté lorsqu'un premier nombre de premiers signaux de décharge partielle est détecté pendant un premier nombre de cycles successifs de la tension alternative en relation avec un premier groupe de valeurs de tension de la tension alternative, et un second nombre de seconds signaux de décharge partielle est ensuite détecté pendant un second nombre de cycles successifs de la tension alternative en relation avec un second groupe de valeurs de tension de la tension alternative comprenant des valeurs de tension inférieures aux valeurs du premier groupe.

Des modes de réalisation de réalisation de l'invention seront décrits dans ce qui suit à titre non limitatif, en relation avec les figures jointes dans lesquelles :

- la figure 1 représente un exemple de réalisation d'un dispositif selon l'invention de détection d'un défaut d'isolement dans un réseau électrique,
- les figures 2A à 2F représentent des signaux apparaissant dans le dispositif de la figure 1, et
- la figure 3 représente des étapes d'un procédé de détection d'un défaut d'isolement mis en oeuvre au moyen du dispositif de la figure 1.

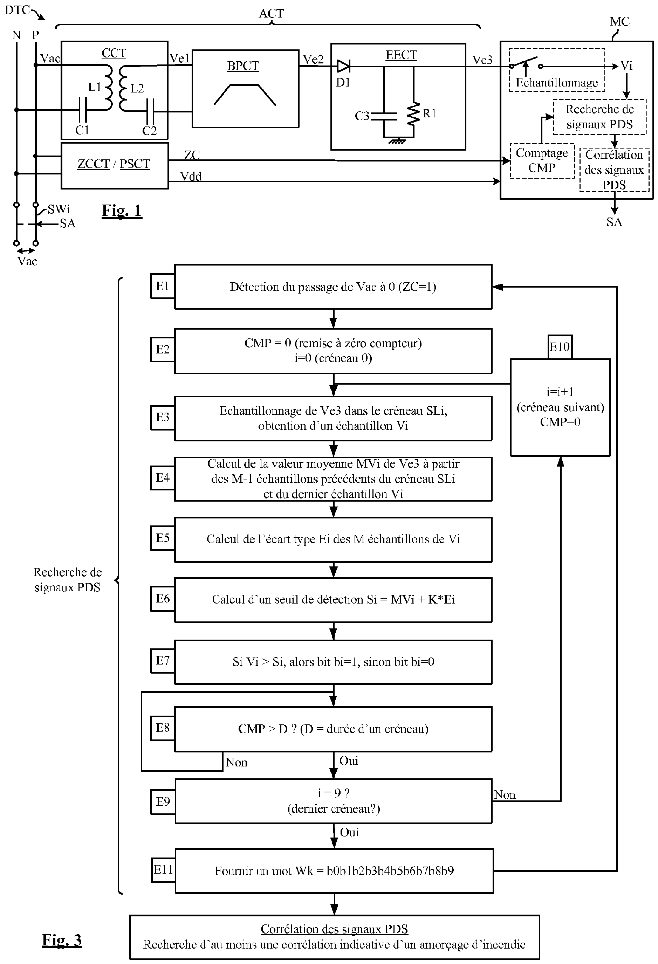

La figure 1 représente un dispositif DTC selon l'invention de détection d'un défaut d'isolement dans un réseau électrique. Le dispositif DTC est connecté ici à un réseau électrique comprenant un fil de neutre N et un fil de phase P, et est configuré ici pour détecter un amorçage d'incendie. Le réseau véhicule une tension alternative Vac, par exemple une tension de 240 V d'une fréquence de 50 Hz.

Le dispositif DTC comprend un circuit d'acquisition ACT, un circuit de traitement MC, un circuit ZCTT de détection de passage à zéro ("Zero Crossing Circuit"), et un circuit d'alimentation électrique PSCT.

Le circuit ZCCT reçoit la tension Vac et fournit un signal logique ZC présentant un front de variation déterminé à chaque passage à zéro de la tension Vac, par exemple un front montant (passage de 0 à 1). Le circuit d'alimentation PSCT reçoit également la tension Vac et fournit une tension continue Vdd au circuit de traitement MC. Le circuit d'acquisition ACT extrait de la tension alternative Vac un signal Ve3 susceptible de contenir des signaux de décharge partielle. Le circuit de traitement MC analyse le signal Ve3 pour détecter un amorçage d'incendie.

Le circuit d'acquisition ACT comprend un circuit coupleur CCT recevant la tension Vac et fournissant un signal Ve1, un circuit passe bande BPCT recevant le signal Ve1 et fournissant un signal Ve2, et un circuit d'extraction d'enveloppe EECT recevant le signal Ve2 et fournissant le signal Ve3. Les signaux Ve1, Ve2, Ve3 sont ici des signaux en tension.

Le circuit coupleur CCT comprend ici un transformateur d'isolement comportant une bobine primaire L1 connectée au réseau et une bobine secondaire L2 fournissant le signal Ve1. Un condensateur C1 agencé en série avec la bobine primaire L1 et un condensateur C2 agencé en série avec la bobine secondaire L2 confèrent au circuit CCT une fonction de filtrage passe-haut permettant d'éliminer la composante 50 Hz de la tension Vac.

Les signaux de décharge partielle générateurs d'incendie présentent un large spectre de fréquences et sont donc susceptibles d'être détectés dans toutes bandes de fréquences. Toutefois, certaines bandes de fréquences sont "polluées" par des signaux pouvant avoir l'apparence de signaux de décharge partielle, notamment des signaux générés par les dispositifs de transmission de données à courant porteur. Dans un mode de réalisation de l'invention, on préfère donc réduire la bande d'analyse du signal Ve1 au moyen du circuit passe-bande BPCT, de manière à éliminer des fréquences de transmission de données par courants porteurs. Un autre paramètre dictant le choix de la bande passante du circuit BPCT est la durée de créneaux temporels décrits plus loin. A titre d'exemple, la bande passante du circuit BPCT est de 145 kHz à 1,7 Mhz en Europe et de 500 kHz à 1,7 Mhz aux États-Unis.

Le circuit d'extraction d'enveloppe EECT est réalisé ici sous la forme d'un circuit intégrateur semi-alternance. Il comprend une diode de redressement semi-alternance D1 dont l'anode reçoit le signal Ve2. La cathode de la diode D1 est reliée à la masse par l'intermédiaire d'un condensateur C3 en parallèle avec une résistance R1, et fournit le signal Ve3 au circuit de traitement MC. Le circuit R1C3 assure le lissage du signal redressé Ve3, ce qui correspond à une intégration de ce signal. Le circuit R1C3 présente une constante de temps RC qui est inférieure à la durée de créneaux temporels décrits plus loin, par exemple égale à la moitié de cette durée, soit 0,5 ms en relation avec l'exemple décrit plus loin. Le signal Ve3 est un signal bruité susceptible de contenir des signaux de décharge partielle.

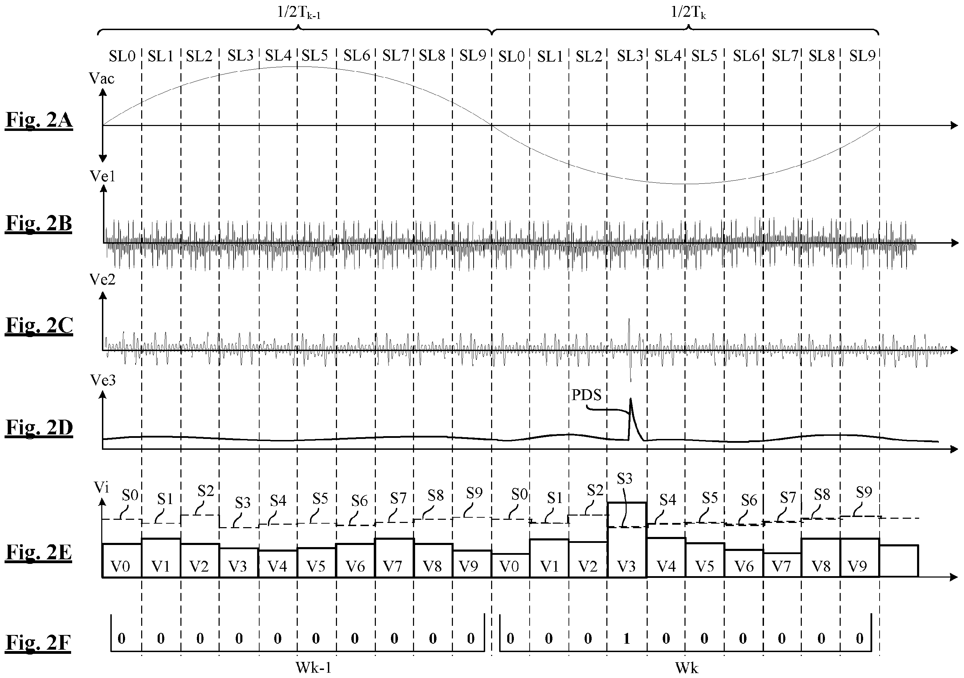

Les figures 2A, 2B, 2C et 2D représentent respectivement la tension Vac, le signal Ve1, le signal Ve2 et le signal Ve3. Ces signaux sont représentés schématiquement à titre d'illustration uniquement et leur forme est arbitraire. Le signal Ve3 présente un pic PDS formant un signal de décharge partielle.

Le circuit de traitement MC analyse le signal Ve3 pour y détecter des signaux de décharge partielle PDS. Il réalise ensuite une sorte de "tri" pour différentier les signaux PDS qui sont représentatifs d'un amorçage d'incendie et ceux qui ne le sont pas. Ce tri est réalisé en appliquant une ou plusieurs règles de corrélation qui tiennent compte de la position des signaux PDS sur la courbe de la tension alternative Vac.

A cet effet, le circuit MC définit des créneaux temporels SLi ("time slots"), désignés dans ce qui suit "créneaux" ("slots"), dans lesquels il analyse le signal Ve3. Ces créneaux sont synchronisés à la tension alternative Vac au moyen du signal logique ZC, et représentent chacune une fraction d'un cycle de la tension Vac. Ils sont ici de durée constante et égale à 1/N fois la période T de la tension Vac, N étant un entier représentant le nombre de créneaux par période T. Chaque créneau SLi présente un rang i déterminé relativement au passage à zéro de la tension Vac et correspond ainsi à un groupe de valeurs de tension de la tension alternative Vac.

Le signal Ve3 étant ici redressé en semi-alternance par le circuit d'extraction d'enveloppe EECT, le circuit de traitement MC ne fait pas la distinction entre les alternances positives et négatives de la tension Vac. La durée des créneaux est donc ici égale à 1/N fois la demi-période T, soit 1/2N fois la période T.

Dans l'exemple de réalisation représenté sur les figures 2A à 2F, le paramètre N est choisit égal à 10. On distingue ainsi dix créneaux SL0 à SL9 par demi-période de la tension Vac, le premier créneau SL0 étant placé après le passage à zéro de la tension Vac, le dernier créneau SL9 étant placé avant le passage à zéro suivant de la tension Vac. Chaque créneau SLi présente une durée de 1 ms si la tension Vac présente une fréquence de 50 Hz et une période T de 20 ms.

Le circuit de traitement MC est ici un microcontrôleur équipé d'une entrée d'échantillonnage et de numérisation du signal Ve3. Le traitement du signal Ve3 est donc réalisé sur des échantillons numériques Vi de ce signal, représentés sur la figure 2E. L'échantillonnage est réalisé par exemple à une fréquence de 100 kHz, soit 100 échantillons Vi,j du signal par créneau, i étant le rang du créneau considéré et j le rang de l'échantillon dans le créneau considéré. Le microcontrôleur ramène ces 100 échantillons Vi,j à un seul échantillon Vi par créneau, par exemple en choisissant comme échantillon Vi l'échantillon Vi,j ayant la valeur la plus élevée sur les 100 échantillons Vi,j, ou en calculant la valeur moyenne des 100 échantillons Vi,j.

Le traitement du signal Ve3 numérisé et échantillonné comprend deux phases principales :

- une phase de détection de signaux PDS, et
- une phase de détection d'un amorçage d'incendie, ou phase de corrélation, visant à mettre en évidence une corrélation représentative d'un amorçage d'incendie entre les différents signaux PDS détectés.

On désigne ici par "signal PDS" ou "signal de décharge partielle PDS" tout signal ayant le profil d'un "vrai" signal de décharge partielle mais pouvant avoir une origine autre qu'un défaut d'isolement pouvant conduire à un amorçage d'incendie. Il peut s'agir par exemple de signaux émis par des systèmes d'éclairage ou des appareillages connectés au réseau. La distinction entre les "vrais" et "faux" signaux de décharge partielle est faite au cours de la phase de corrélation.

Phase de détection de signaux de décharge partielle

La phase de détection de signaux PDS est illustrée par l'organigramme sur la figure 3 et comprend des étapes E1 à E11.

A l'étape E1, le microcontrôleur est informé du passage à zéro de la tension alternative Vac grâce au passage à 1 du signal ZC. A l'étape E2, le microcontrôleur remet à 0 une valeur de comptage CMP. Cette valeur est constamment incrémentée par un compteur du microcontrôleur cadencé par un signal horloge (non représenté sur la figure 1). Cette valeur de comptage permet au microcontrôleur de distinguer les différents créneaux. Le microcontrôleur met également à 0 l'indice i des créneaux après passage à zéro de la tension Vac.

Les étapes E3 à E8 sont répétées par le microcontrôleur pour chaque créneaux SLi, à commencer par le créneau SL0. A l'étape E3, le microcontrôleur échantillonne et numérise le signal Ve3 pour prélever un échantillon Vi représentatif de l'amplitude du signal Ve3 dans le créneau considéré SLi. L'échantillon Vi est déterminé comme indiqué plus haut, par sélection du plus grand des échantillons Vi,j ou par calcul de la valeur moyenne des échantillons Vi,j dans le créneau SLi.

A l'étape E4, le microcontrôleur calcule une valeur moyenne MVi du signal Ve3 dans le créneau considéré SLi, à partir de M échantillons Vi. Ces M échantillons Vi comprennent l'échantillon courant Vi qui vient d'être prélevé et M-1 échantillons Vi prélevés dans ce même créneau au cours de cycles précédents de la tension alternative Vac. A l'instar des M-1 échantillons précédents, l'échantillon courant Vi est également mémorisé afin de permettre au microcontrôleur de recalculer la valeur moyenne MVi à la prochaine demi-période de la tension Vac. Le plus ancien des M-1 échantillons est effacé afin de ne pas saturer la mémoire du microcontrôleur. Le nombre M est par exemple égal à 1000, ce qui implique de mémoriser 1000 échantillons Vi par créneau soit 10000 échantillons au total pour les 10 créneaux SL0 à SL9.

A l'étape E5, le microcontrôleur calcule l'écart-type Ei des M échantillons utilisés pour le calcul de la valeur moyenne. A l'étape E6, le microcontrôleur calcule un seuil de détection dynamique $Si = MVi + K*Ei$ en ajoutant K fois l'écart-type à la valeur moyenne MVi, K étant au moins égal à 1. A l'étape E7, le microcontrôleur détermine si l'échantillon Vi est supérieur au seuil dynamique Si. Dans l'affirmative, le microcontrôleur considère qu'un signal de décharge partielle a été détecté dans le créneau considéré et met à 1 un bit bi de rang i correspondant au rang i du créneau considéré SLi. Dans la négative, le microcontrôleur considère qu'un signal de décharge partielle n'a pas été détecté et met le bit bi à 0.

La valeur $K*Ei$ correspond à un intervalle de variation acceptable du signal Ve3 relativement à sa valeur moyenne MVi dans le créneau considéré. Un échantillon Vi présentant une valeur en dessous du seuil $MVi + K*Ei$ n'est pas considéré comme représentatif de la présence d'un signal PDS. Cet intervalle de variation permet au microcontrôleur de ne pas être aveuglé par des sauts de valeurs des échantillons Vi qui sont statistiquement acceptables et situés sur la partie centrale d'une courbe gaussienne des variations du signal Ve3. Le coefficient K peut être choisi égal à 3, ce qui signifie que ne seront pas considérés comme des signaux PDS des variations du signal Ve3 inférieures à 3 fois l'écart type Ei dans le créneau considéré. L'homme de l'art pourra bien entendu retenir d'autres moyens de détermination de l'intervalle de variation acceptable, qui ne sont pas basés sur un calcul d'écart-type.

A l'étape E8, le microcontrôleur consulte la valeur de comptage CMP et détermine si elle est supérieure à un nombre D correspondant à la durée d'un créneau. Dans la négative, le microcontrôleur réitère l'étape E8 jusqu'à ce que le nombre D soit atteint.

A l'étape E9, le microcontrôleur détermine si le créneau actuel de rang i est le dernier créneau de la demi-période de la tension Vac, en déterminant si i=9.

Dans la négative, le microcontrôleur va à l'étape E10 où il incrémente le rang i du créneau (i=i+1), remet à 0 la valeur de comptage CMP, puis répète les étapes E3 à E9.

Dans l'affirmative, le microcontrôleur va à l'étape E11 où il génère un mot binaire Wk comprenant l'ensemble des bits bi configurés à l'étape E7 pour chacun des créneaux, soit ici Wk=b0b1b2b3b4b5b6b7b8b9. Le microcontrôleur retourne ensuite à l'étape E1 pour détecter le passage à zéro de la tension Vac et répète les étapes E2 à E11, et ainsi de suite.

A titre d'illustration, deux demi-périodes $1/2T_{k-1}$ et $1/2T_k$ sont représentées sur les figures 2A à 2F. La figure 2E montre la valeur des échantillons Vi dans chaque créneau SL0 à SL9 ainsi que les valeurs des seuils de détection dynamiques S0 à S9 qui sont calculés par le microcontrôleur pour chaque créneau au cours de chaque étape E6. Il apparaît qu'au cours de la demi-période $1/2T_{k-1}$, aucun des échantillons calculés Vi ne présente une valeur supérieure au seuil de détection correspondant Si. Le mot binaire correspondant $W_{k-1}$ ne comprend donc que des bits à 0. Au cours de la demi-période suivante $1/2T_{k-1}$, seul l'échantillon V3 du quatrième créneau SL3 présente une valeur supérieure au seuil de détection correspondant S3. Le quatrième bit b3 du mot binaire correspondant $W_k$ est donc égal à 1 tandis que les autres bits sont à 0, le mot $W_k$ étant ainsi égal à 0001000000.

L'homme de l'art notera que le mode de réalisation du procédé de l'invention qui vient d'être décrit a été présenté sous forme d'organigramme récursif dans un souci de simplification de la description. Ce procédé peut comprendre en pratique des étapes de traitements exécutées en mode multitâche qui sont quasi-simultanées. Notamment, l'étape E1 de détection du passage à zéro de la tension Vac, les étapes E2 et E10 de remise à zéro de la valeur de comptage, et l'étape E8 de surveillance de la valeur de comptage peuvent être exécutées en boucle pendant la durée d'un créneau et simultanément à l'exécution des étapes de calcul E4 à E7. De même, les étapes de calcul E4 à E7 peuvent être effectuées en temps différé si l'étape échantillonnage E3 s'étend pendant toute la durée du créneau considéré, notamment lorsque le microcontrôleur prélève 100 échantillons Vi,j par créneau et détermine la valeur de l'échantillon Vi.

Également, la phase de détection d'un amorçage d'incendie qui va maintenant être décrite peut être conduite en même temps que la phase de détection de signaux PDS, avec un décalage d'une demi-période ou plus. Par exemple, pendant que le microcontrôleur conduit la phase de détection de signaux PDS sur une demi-période de la tension Vac, il peut exécuter en même temps la phase de détection d'un amorçage d'incendie en se basant sur les signaux PDS détectés au cours des demi-périodes précédentes.

Phase de détection d'un amorçage d'incendie

La recherche d'une corrélation représentative d'un amorçage d'incendie entre les différents signaux PDS détectés est faite en tenant compte de leur position sur la courbe de la tension alternative Vac, soit ici en tenant compte des créneaux SLi dans lesquels ils ont été détectés. Le microcontrôleur dispose d'une ou de plusieurs règles de corrélation COR1, COR2, COR3,... déterminées par des essais et expérimentations. Une alerte est déclenchée lorsqu'au moins l'une de ces règles de corrélation est satisfaite. Lorsqu'une alerte est déclenchée, le microcontrôleur met en oeuvre une contre-mesure permettant d'éviter un incendie. Par exemple, comme montré sur la figure 1, le microcontrôleur peut fournir un signal d'alerte SA qui ouvre des interrupteurs SWi par l'intermédiaire desquels la tension alternative Vac est appliquée au réseau.

Des exemples de règles de corrélation COR1 à COR3 seront décrits dans ce qui suit à titre non limitatif.

Exemple 1 - Règle COR1 : Une alerte est déclenchée si un nombre N1 de signaux PDS successifs a été détecté dans un même créneau SLi au cours de cycles successifs de la tension Vac.

La règle COR1 est fondée sur l'hypothèse que l'apparition de signaux PDS successifs dans le même créneau est représentative d'un amorçage d'incendie. Si par exemple N1=3, une alerte sera par exemple déclenchée lorsque le microcontrôleur génère les mots suivants (apparitions successives de trois signaux PDS dans le quatrième créneau (3):

$$W0 = 000\mathbf{1}000000$$

$$W1 = 000\mathbf{1}000000$$

$$W2 = 0001000000$$

Exemple 2 - Règle COR2 : un nombre $N1$ de signaux PDS a été détecté dans un même créneau $SLi$, pendant $P1$ demi-périodes successives de la tension Vac. Une alerte est déclenchée si $N1 > 0,5\ P1$.

La règle COR2 est fondée sur l'hypothèse que l'apparition répétitive de signaux PDS dans le même créneau est représentative d'un amorçage d'incendie si ces signaux sont assez proches les uns des autres et même s'ils ne sont pas successifs. Si par exemple $P1 = 5$, le seuil d'alerte est $N1>2$. A titre d'exemple, une alerte sera déclenchée lorsque le microcontrôleur génère les mots suivants (apparitions répétitives mais pas nécessairement successives d'un signal PDS dans le troisième créneau (2):

$$W0 = 0010000000$$

$$W1 = 0000000000$$

$$W2 = 0010000000$$

$$W3 = 0000000000$$

$$W4 = 0010000000$$

Exemple 3 - Règle COR3 : un nombre $N1$ de signaux PDS a été détecté dans un créneau $SLi$ correspondant à une première valeur de tension de la tension alternative Vac, pendant $P1$ demi-périodes successives, puis un nombre $N2$ de signaux PDS a été détecté dans une autre créneau $SLi'$ correspondant à une seconde valeur de tension de la tension alternative Vac inférieure à la première valeur de tension, pendant $P2$ demi-périodes successives suivant les $P1$ première demi-périodes. Une alerte est déclenchée si $N1 > 0,5\ P1$ et $N2 > 0,5\ P2$.

La règle COR3 est fondée sur l'hypothèse que des apparitions répétitives mais pas nécessairement successives de signaux PDS dans un premier créneau puis dans un second créneau correspondant à une valeur inférieure de la tension Vac, est représentative d'un amorçage d'incendie. En effet, un amorçage d'incendie se traduit par une destruction progressive des gaines isolantes et donc une diminution de leur constante diélectrique au point de claquage. L'amplitude de la tension Vac à laquelle les décharges partielles se produisent tend donc à baisser au fur et à mesure que l'isolant se détériore.

Si par exemple $P1=5$ et $P2= 4$, les seuils d'alerte sont $N1>2$ et $N2>2$. A titre d'exemple, une alerte sera déclenchée lorsque le microcontrôleur génère les mots suivants (apparitions répétitives d'un signal PDS dans le cinquième créneau SL4 puis dans le quatrième créneau (3):

$$W0 = 0000100000$$

$$W1 = 0000000000$$

$$W2 = 0000100000$$

$$W3 = 0000000000$$

$$W4 = 0000100000$$

$$W5 = 0001000000$$

$$W6 = 0000000000$$

$$W7 = 0001000000$$

$$W8 = 0001000000$$

Les critères de corrélation intervenant dans les règles COR2 et COR3 peuvent être rendus plus stricts en prévoyant que les signaux PDS soient successifs et pas simplement répétitifs, ce qui conduit à imposer que P1 soit égal à N1 dans la règle COR2, laquelle devient alors similaire à la règle COR1, et à imposer que P1 soit égal à N1 et P2 égal à N2 dans la règle COR2.

Dans ce cas, Si par exemple P1=5 et P2= 4, une alerte sera déclenchée lorsque le microcontrôleur génère les mots suivants (apparitions successives de 5 signaux PDS dans le cinquième créneau SL4 puis de 4 signaux PDS dans le quatrième créneau SL3):

$$W0 = 0000100000$$

$$W1 = 0000100000$$

$$W2 = 0000100000$$

$$W3 = 0000100000$$

$$W4 = 0000100000$$

$$W5 = 0001000000$$

$$W6 = 0001000000$$

$$W7 = 0001000000$$

$$W8 = 0001000000$$

Il apparaîtra clairement à l'homme de l'art que la présente invention est susceptible de diverses variantes et modes de réalisation.

Ainsi, dans un mode de réalisation, le circuit d'acquisition ACT est réalisé différemment et est par exemple basé sur une détection de courant.

Dans un autre mode de réalisation, le rang i des créneaux est déterminé relativement à une autre valeur de tension de la tension Vac, par exemple sa valeur crête.

Dans encore un autre mode de réalisation, la recherche d'une corrélation entre les signaux PDS est assurée par un circuit de calcul externe recevant les mots binaires Wk fournis par le microcontrôleur.

Dans encore un autre mode de réalisation, le circuit de traitement MC, au lieu d'être un microcontrôleur, comprend une chaîne de traitement analogique configurée pour détecter les signaux PDS et fournir, à chaque fois qu'un signal PDS est détecté, un signal analogique dont la valeur ou l'amplitude est représentative du temps écoulé entre l'instant où le signal PDS a été détecté et l'instant où la tension Vac est passée à zéro (ou autre valeur de référence). Dans un tel mode de réalisation, la notion de créneau temporel est implicite dans la détermination d'une corrélation entre les signaux PDS, puisque l'amplitude de la tension Vac est directement fonction du temps après chaque passage à zéro.

Dans encore un autre mode de réalisation, le circuit de détection du passage à zéro ZCCT est remplacé par un circuit de mesure VMCT1 configuré pour mesurer la tension Vac et définir des groupes VGi de valeurs de la tension Vac, par exemple 25 groupes de valeurs VG0 à VG24 d'une étendue de 20V chacun, comme montré ci-dessous :

| VG0 | VG1 | ... | VG11 | VG12 | VG13 | VG14 | ... | VG23 | VG24 |
|------|-------|-----|---------|---------|---------|---------|-----|-------|------|
| 0-20 | 20-40 | ... | 200-220 | 220-240 | 240-220 | 220-200 | ... | 40-20 | 20-0 |

Une information correspondant aux groupes de valeurs de tension est fournie au circuit de traitement MC en temps réel. Le circuit de traitement recherche une corrélation entre les signaux PDS en utilisant ces groupes de valeurs en lieu et place des créneaux temporels.

Les groupes de valeurs de tension de la tension Vac pourraient également présenter un incrément de tension variable, par exemple de 20V jusqu'à 100V, de 10V entre 100 et 200V et de 5V entre 200 et 240V. De même, les créneaux temporels précédemment décrits pourraient présenter un incrément temporel variable.

Dans encore un autre mode de réalisation, le circuit de détection du passage à zéro ZCCT est remplacé par un circuit de mesure VMCT2 configuré pour mesurer la tension Vac et fournir en temps réel au circuit de traitement MC un paramètre indicatif de la valeur de la tension Vac, par exemple un signal binaire codé sur plusieurs bits. Le circuit de traitement associe à chaque signal PDS détecté le paramètre indicatif reçu au moment où le signal PDS a été détecté, ce paramètre formant alors un paramètre indicatif de la position du signal PDS sur la courbe de la tension Vac. Le circuit de traitement recherche ensuite une corrélation entre les signaux PDS en utilisant ce paramètre indicatif à la place des groupes de valeurs de tension de la tension Vac ou des créneaux temporels.

Ainsi, dans la présente demande, les notions de créneaux temporels, de groupes de valeurs de tension de la tension alternative Vac ou de paramètre indicatif de la position d'un signal PDS sur la courbe de la tension alternative Vac, sont considérées comme équivalentes. Si la tension Vac est sinusoïdale, des créneaux temporels de durée fixe correspondent à des groupes de valeurs de tension de la tension Vac d'étendue variable, et des groupes de valeurs de tension de la tension Vac d'étendue fixe correspondent à des créneaux temporels de durée variable.

La présente invention est également susceptible de diverses applications. Ainsi, des phénomènes transitoires identiques peuvent être observés dans une installation de panneaux photovoltaïques comprenant des diodes présentant un défaut d'isolement. Un procédé de détection selon l'invention s'applique également à ce type de réseau électrique et peut permettre une amélioration de la maintenance des installations de production énergétique. Dans ce cas, les règles de corrélation spécifiques à ce type de défaut d'isolement sont définies, toujours en relation avec la position des impulsions de décharge partielle sur la courbe de la tension alternative véhiculée par le réseau sous surveillance.

**Revendications**

1.  Dispositif (DTC) de détection, dans un réseau électrique véhiculant une tension alternative basse tension (Vac), d'un défaut d'isolement entre un fil de phase (P) et un fil de neutre (N) se traduisant par l'apparition de signaux de décharge partielle (PDS), comprenant des moyens de détection de signaux de décharge partielle par analyse de la tension (Vac) ou du courant véhiculé par le réseau électrique, **caractérisé en ce qu'**il comprend des moyens pour :

> - associer à chaque signal de décharge partielle détecté un paramètre (SLi, VGi) indicatif de la position du signal de décharge partielle sur la courbe de la tension alternative, et
> - rechercher s'il existe, entre plusieurs signaux de décharge partielle détectés pendant des cycles de variation différents de la tension alternative, au moins une corrélation (COR1, COR2, COR3) indicative d'un défaut d'isolement, en tenant compte du paramètre (SLi, VGi) indicatif de la position du signal de décharge partielle sur la courbe de la tension alternative.

2.  Dispositif selon la revendication 1, configuré pour :

- définir comme paramètre indicatif de la position d'un signal de décharge partielle sur la courbe de la tension alternative (Va), des groupes (SLi, VGi) de valeurs de tension de la tension alternative, et
- associer à chaque signal de décharge détecté un groupe (SLi, VGi) de valeurs de tension de la tension alternative.

3. Dispositif selon la revendication 2, configuré pour identifier chaque groupe (VGi) de valeurs de tension de la tension alternative au moyen d'un créneau temporel (SLi) représentant une fraction de la période (T) de la tension alternative.

4. Dispositif selon l'une des revendications 2 et 3, configuré pour détecter un défaut d'isolement lorsqu'un premier nombre (N1) de signaux de décharge partielle est détecté pendant un premier nombre (P1) de cycles successifs de la tension alternative en relation avec un même groupe (SLi, VGi) de valeurs de tension de la tension alternative.

5. Dispositif selon l'une des revendications 2 à 4, configuré pour détecter un défaut d'isolement lorsque :

- un premier nombre (N1) de signaux de décharge partielle est détecté pendant un premier nombre (P1) de cycles successifs de la tension alternative en relation avec un premier groupe de valeurs de tension de la tension alternative, et
- un second nombre (N2) de signaux de décharge partielle est ensuite détecté pendant un second nombre (P2) de cycles successifs de la tension alternative en relation avec un second groupe de valeurs de tension de la tension alternative comprenant des valeurs de tension inférieures aux valeurs du premier groupe.

6. Dispositif selon l'une des revendications 1 à 5, dans lequel les moyens de détection de signaux de décharge partielle comprennent :

- un circuit d'acquisition (ACT) pour extraire de la tension alternative un signal de référence (Ve3) susceptible de contenir des signaux de décharge partielle,
- un circuit (MC) de traitement du signal de référence, configuré pour, pour chaque groupe (SLi, VGi) de valeurs de tension de la tension alternative (Vac) :

  - déterminer une valeur actuelle (Vi) de l'amplitude du signal de référence (Ve3),
  - calculer une valeur moyenne (MVi) de l'amplitude du signal de référence d'enveloppe à partir de la valeur actuelle (Vi) de l'amplitude du signal de référence et de M-1 valeurs précédentes de l'amplitude du signal de référence mesurées au cours de cycles précédents de la tension alternative en relation avec le groupe de valeurs de tension de la tension alternative considéré,
  - déterminer un seuil de détection (Si, S1-S9) qui est fonction de la valeur moyenne (MVi) de l'amplitude du signal de référence, et
  - détecter un signal de décharge partielle si la valeur actuelle (Vi) de l'amplitude du signal de référence est supérieure au seuil de détection (Si, S1-S9).

7. Dispositif selon la revendication 6, dans lequel le circuit d'acquisition (ACT) comprend un circuit intégrateur (EECT, D1, R1, C3) recevant en entrée un signal filtré (Ve2) extrait de la tension alternative et fournissant le signal de référence (Ve3).

8. Dispositif selon l'une des revendications 6 et 7, dans lequel le circuit de détection (MC) est configuré pour numériser le signal de référence (Ve3) pour chaque groupe (SLi, VGi) de valeurs de tension de la tension alternative, et fournir un échantillon numérique (Vi) représentatif de l'amplitude du signal de référence (Ve3) en relation avec le groupe de valeurs de tension de la tension alternative considéré.

9. Dispositif selon la revendication 8, dans lequel le circuit de détection (MC) est configuré pour calculer la valeur moyenne (MVi) de l'amplitude du signal de référence (Ve3) à partir d'un groupe de M échantillons numériques (Vi) comprenant l'échantillon numérique (Vi) représentatif de l'amplitude actuelle du signal de référence (Ve3) et M-1 échantillons numériques (Vi) représentatifs de l'amplitude du signal de référence (Ve3) au cours de cycles précédents de la tension alternative en relation avec le même groupe de valeurs de tension de la tension alternative.

10. Dispositif selon l'une des revendications 6 à 9, dans lequel le circuit de détection est configuré pour générer des mots binaires (Wj) de N bits (b0-b9) dans lesquels chaque bit est associé à un groupe (SLi, VGi) de valeurs de tension de la tension alternative, et présente une première valeur si un signal de décharge partielle a été détecté en relation avec le groupe de valeurs de tension de la tension alternative considéré et une second valeur logique si un signal de décharge partielle n'a pas été détecté en relation avec le groupe de valeurs de tension considéré.

11. Procédé de détection d'un défaut d'isolement entre un fil de phase (P) et un fil de neutre (N) dans un réseau électrique véhiculant une tension alternative (Vac) basse tension, comprenant des étapes de détection de signaux de décharge partielle par analyse de la tension (Vac) ou du courant véhiculé par le réseau électrique, **caractérisé en ce qu'**il comprend des étapes consistant à :

- associer à chaque signal de décharge partielle détecté un paramètre (SLi, VGi) indicatif de la position du signal de décharge partielle sur la courbe de la tension alternative,
- rechercher s'il existe, entre plusieurs signaux de décharge partielle détectés pendant des cycles de variation différents de la tension alternative, au moins une corrélation (COR1, COR2, COR3) indicative d'un défaut d'isolement, en tenant compte du paramètre (SLi, VGi) indicatif de la position du signal de décharge partielle sur la courbe de la tension alternative.

12. Procédé selon la revendication 11, comprenant les étapes consistant à :

- définir comme paramètre indicatif de la position d'un signal de décharge partielle sur la courbe de la tension alternative, des groupes (VGi) de valeurs de tension de la tension alternative, et
- associer à chaque signal de décharge détecté un groupe (VGi) de valeurs de tension de la tension alternative.

13. Procédé selon la revendication 12, dans lequel chaque groupe (VGi) de valeurs de tension de la tension alternative est identifié au moyen d'un créneau temporel (SLi) représentant une fraction de la période (T) de la tension alternative.

14. Procédé selon l'une des revendications 12 et 13, dans lequel un défaut d'isolement est détecté lorsqu'un premier nombre (N1) de signaux de décharge partielle est détecté pendant un premier nombre (P1) de cycles successifs de la tension alternative en relation avec le même groupe (SLi, VGi) de valeurs de tension de la tension alternative.

15. Procédé selon l'une des revendications 12 à 14, dans lequel un défaut d'isolement est détecté lorsque :

- un premier nombre (N1) de signaux de décharge partielle est détecté pendant un premier nombre (P1) de cycles successifs de la tension alternative en relation avec un premier groupe de valeurs de tension de la tension alternative, et
- un second nombre (N2) de signaux de décharge partielle est ensuite détecté pendant un second nombre (P2) de cycles successifs de la tension alternative en relation avec un second groupe de valeurs de tension de la tension alternative comprenant des valeurs de tension inférieures aux valeurs du premier groupe.

**Patentansprüche**

1. Vorrichtung (DTC) zur Erkennung, in einem eine Niederspannungs-Wechselspannung (Vac) transportierenden Stromnetz, eines Isolationsfehlers zwischen einem Phasendraht (P) und einem Nullleiterdraht (N), der sich durch das Auftreten von Teilentladungssignalen (PDS) äußert, die Einrichtungen zur Erkennung von Teilentladungssignalen durch Analyse der Spannung (Vac) oder des vom Stromnetz transportierten Stroms enthält, **dadurch gekennzeichnet, dass** sie Einrichtungen enthält, um:

- jedem erkannten Teilentladungssignal einen Parameter (SLi, VGi) zuzuordnen, der die Position des Teilentladungssignals auf der Kurve der Wechselspannung bezeichnet, und
- zu suchen, ob es unter mehreren während unterschiedlicher Änderungszyklen der Wechselspannung erkannten Teilentladungssignalen mindestens eine einen Isolationsfehler bezeichnende Korrelation (COR1, COR2, COR3) gibt, unter Berücksichtigung des die Position des Teilentladungssignals auf der Kurve der Wechselspannung bezeichnenden Parameters (SLi, VGi).

2. Vorrichtung nach Anspruch 1, die konfiguriert ist:

- als die Position eines Teilentladungssignals auf der Kurve der Wechselspannung (Va) bezeichnenden Parameter Gruppen (SLi, VGi) von Spannungswerten der Wechselspannung zu definieren, und
- jedem erkannten Entladungssignal eine Gruppe (SLi, VGi) von Spannungswerten der Wechselspannung zuzuordnen.

3.  Vorrichtung nach Anspruch 2, die konfiguriert ist, jede Gruppe (VGi) von Spannungswerten der Wechselspannung mittels eines Zeitschlitzes (SLi) zu bestimmen, der einen Bruchteil der Periode (T) der Wechselspannung darstellt.

4.  Vorrichtung nach einem der Ansprüche 2 und 3, die konfiguriert ist, einen Isolationsfehler zu erkennen, wenn eine erste Anzahl (N1) von Teilentladungssignalen während einer ersten Anzahl (P1) von aufeinanderfolgenden Zyklen der Wechselspannung in Verbindung mit der gleichen Gruppe (SLi, VGi) von Spannungswerten der Wechselspannung erkannt wird.

5.  Vorrichtung nach einem der Ansprüche 2 bis 4, die konfiguriert ist, einen Isolationsfehler zu erkennen, wenn:

    - eine erste Anzahl (N1) von Teilentladungssignalen während einer ersten Anzahl (P1) von aufeinanderfolgenden Zyklen der Wechselspannung in Verbindung mit einer ersten Gruppe von Spannungswerten der Wechselspannung erkannt wird, und
    - eine zweite Anzahl (N2) von Teilentladungssignalen anschließend während einer zweiten Anzahl (P2) von aufeinanderfolgenden Zyklen der Wechselspannung in Verbindung mit einer zweiten Gruppe von Spannungswerten der Wechselspannung erkannt wird, die niedrigere Spannungswerte als die Werte der ersten Gruppe enthält.

6.  Vorrichtung nach einem der Ansprüche 1 bis 5, wobei die Einrichtungen zur Erkennung von Teilentladungssignalen enthalten:

    - eine Erfassungsschaltung (ACT), um aus der Wechselspannung ein Bezugssignal (Ve3) zu extrahieren, das Teilentladungssignale enthalten kann,
    - eine Schaltung (MC) zur Verarbeitung des Bezugssignals, die konfiguriert ist, für jede Gruppe (SLi, VGi) von Spannungswerten der Wechselspannung (Vac):

        - einen aktuellen Wert (Vi) der Amplitude des Bezugssignals (Ve3) zu bestimmen,
        - einen Mittelwert (MVi) der Amplitude des Hüllkurven-Bezugssignals ausgehend vom aktuellen Wert (Vi) der Amplitude des Bezugssignals und von M-1 vorhergehenden Werten der Amplitude des Bezugssignals zu berechnen, die während vorhergehender Zyklen der Wechselspannung in Verbindung mit der betrachteten Gruppe von Spannungswerten der Wechselspannung gemessen wurden,
        - eine Erkennungsschwelle (Si, S1-S9) zu bestimmen, die vom Mittelwert (MVi) der Amplitude des Bezugssignals abhängt, und
        - ein Teilentladungssignal zu erkennen, wenn der aktuelle Wert (Vi) der Amplitude des Bezugssignals höher als die Erkennungsschwelle (Si, S1-S9) ist.

7.  Vorrichtung nach Anspruch 6, wobei die Erfassungsschaltung (ACT) eine Integrierschaltung (EECT, D1, R1, C3) enthält, die am Eingang ein aus der Wechselspannung extrahiertes gefiltertes Signal (Ve2) empfängt und das Bezugssignal (Ve3) liefert.

8.  Vorrichtung nach einem der Ansprüche 6 und 7, wobei die Erkennungsschaltung (MC) konfiguriert ist, das Bezugssignal (Ve3) für jede Gruppe (SLi, VGi) von Spannungswerten der Wechselspannung zu digitalisieren und eine digitalisierte Tastprobe (Vi) zu liefern, die für die Amplitude des Bezugssignals (Ve3) in Verbindung mit der betrachteten Gruppe von Spannungswerten der Wechselspannung repräsentativ ist.

9.  Vorrichtung nach Anspruch 8, wobei die Erkennungsschaltung (MC) konfiguriert ist, den Mittelwert (MVi) der Amplitude des Bezugssignals (Ve3) ausgehend von einer Gruppe von M digitalen Tastproben (Vi) zu berechnen, die die für die aktuelle Amplitude des Bezugssignals (Ve3) repräsentative digitale Tastprobe (Vi) und M-1 für die Amplitude des Bezugssignals (Ve3) während vorhergehender Zyklen der Wechselspannung in Verbindung mit der gleichen Gruppe von Spannungswerten der Wechselspannung repräsentative digitale Tastproben (Vi) enthält.

10. Vorrichtung nach einem der Ansprüche 6 bis 9, wobei die Erkennungsschaltung konfiguriert ist, Binärwörter (Wj) von N Bits (b0-b9) zu generieren, in denen jedes Bit einer Gruppe (SLi, VGi) von Spannungswerten der Wechselspannung zugeordnet ist, und einen ersten Wert, wenn ein Teilentladungssignal in Verbindung mit der betrachteten Gruppe von Spannungswerten der Wechselspannung erkannt wurde, und einen zweiten logischen Wert aufweist, wenn kein Teilentladungssignal in Verbindung mit der betrachteten Gruppe von Spannungswerten erkannt wurde.

11. Verfahren zur Erkennung eines Isolationsfehlers zwischen einem Phasendraht (P) und einem Nullleiterdraht (N) in einem eine Niederspannungs-Wechselspannung (Vac) transportierenden Stromnetz, das Schritte der Erkennung von Teilentladungssignalen durch Analyse der Spannung (Vac) oder des vom Stromnetz transportierten Stroms enthält, **dadurch gekennzeichnet, dass** es Schritte enthält, die darin bestehen:

- jedem erkannten Teilentladungssignal einen Parameter (SLi, VGi) zuzuordnen, der die Position des Teilentladungssignals auf der Kurve der Wechselspannung bezeichnet,
- zu suchen, ob es unter mehreren während unterschiedlicher Änderungszyklen der Wechselspannung erkannten Teilentladungssignalen mindestens eine einen Isolationsfehler bezeichnende Korrelation (COR1, COR2, COR3) gibt, unter Berücksichtigung des die Position des Teilentladungssignals auf der Kurve der Wechselspannung bezeichnenden Parameters (SLi, VGi).

12. Verfahren nach Anspruch 11, das die Schritte enthält, die darin bestehen:

- als die Position eines Teilentladungssignals auf der Kurve der Wechselspannung bezeichnenden Parameter Gruppen (VGi) von Spannungswerten der Wechselspannung zu definieren, und
- jedem erkannten Entladungssignal eine Gruppe (VGi) von Spannungswerten der Wechselspannung zuzuordnen.

13. Verfahren nach Anspruch 12, wobei jede Gruppe (VGi) von Spannungswerten der Wechselspannung mittels eines Zeitschlitzes (SLi) bestimmt wird, der einen Bruchteil der Periode (T) der Wechselspannung darstellt.

14. Verfahren nach einem der Ansprüche 12 und 13, wobei ein Isolationsfehler erkannt wird, wenn eine erste Anzahl (N1) von Teilentladungssignalen während einer ersten Anzahl (P1) von aufeinanderfolgenden Zyklen der Wechselspannung in Verbindung mit der gleichen Gruppe (SLi, VGi) von Spannungswerten der Wechselspannung erkannt wird.

15. Verfahren nach einem der Ansprüche 12 bis 14, wobei ein Isolationsfehler erkannt wird, wenn:

- eine erste Anzahl (N1) von Teilentladungssignalen während einer ersten Anzahl (P1) von aufeinanderfolgenden Zyklen der Wechselspannung in Verbindung mit einer ersten Gruppe von Spannungswerten der Wechselspannung erkannt wird, und
- eine zweite Anzahl (N2) von Teilentladungssignalen anschließend während einer zweiten Anzahl (P2) von aufeinanderfolgenden Zyklen der Wechselspannung in Verbindung mit einer zweiten Gruppe von Spannungswerten der Wechselspannung erkannt wird, die niedrigere Spannungswerte als die Werte der ersten Gruppe enthält.

## Claims

1. Device (DTC) for detecting, in an electrical network carrying a low-voltage AC voltage (Vac), an insulation fault between a phase wire (P) and a neutral wire (N) manifested in the appearance of partial discharge signals (PDS), comprising means for detecting partial discharge signals by analysing the voltage (Vac) or the current carried by the electrical network, **characterized in that** it comprises means for:

- associating, with each detected partial discharge signal, a parameter (SLi, VGi) indicative of the position of the partial discharge signal on the curve of the AC voltage, and
- searching for the existence, among a plurality of partial discharge signals detected during different variation cycles of the AC voltage, of at least one correlation (COR1, COR2, COR3) indicative of an insulation fault, taking into account the parameter (SLi, VGi) indicative of the position of the partial discharge signal on the curve of the AC voltage.

2. Device according to Claim 1, configured to:

- define, as a parameter indicative of the position of a partial discharge signal on the curve of the AC voltage (Va), groups (SLi, VGi) of voltage values of the AC voltage, and
- associate, with each detected discharge signal, a group (SLi, VGi) of voltage values of the AC voltage.

3. Device according to Claim 2, configured to identify each group (VGi) of voltage values of the AC voltage by means of a time slot (SLi) representing a fraction of the period (T) of the AC voltage.

4. Device according to either of Claims 2 and 3, configured to detect an insulation fault when a first number (N1) of partial discharge signals is detected during a first number (P1) of successive cycles of the AC voltage in relation to the same group (SLi, VGi) of voltage values of the AC voltage.

5. Device according to one of Claims 2 to 4, configured to detect an insulation fault when:

   - a first number (N1) of partial discharge signals is detected during a first number (P1) of successive cycles of the AC voltage in relation to a first group of voltage values of the AC voltage, and
   - a second number (N2) of partial discharge signals is then detected during a second number (P2) of successive cycles of the AC voltage in relation to a second group of voltage values of the AC voltage comprising voltage values lower than the values of the first group.

6. Device according to one of Claims 1 to 5, wherein the means for detecting partial discharge signals comprise:

   - an acquisition circuit (ACT) for extracting, from the AC voltage, a reference signal (Ve3) possibly containing partial discharge signals,
   - a circuit (MC) for processing the reference signal, configured, for each group (SLi, VGi) of voltage values of the AC voltage (Vac), to:

      - determine a current value (Vi) of the amplitude of the reference signal (Ve3),
      - calculate a mean value (MVi) of the amplitude of the envelope reference signal on the basis of the current value (Vi) of the amplitude of the reference signal and M-1 previous values of the amplitude of the reference signal that were measured over previous cycles of the AC voltage in relation to the group of voltage values of the AC voltage in question,
      - determine a detection threshold (Si, S1-S9) that depends on the mean value (MVi) of the amplitude of the reference signal, and
      - detect a partial discharge signal if the current value (Vi) of the amplitude of the reference signal is higher than the detection threshold (Si, S1-S9).

7. Device according to Claim 6, wherein the acquisition circuit (ACT) comprises an integrator circuit (EECT, D1, R1, C3) receiving as input a filtered signal (Ve2) extracted from the AC voltage and delivering the reference signal (Ve3).

8. Device according to either of Claims 6 and 7, wherein the detection circuit (MC) is configured to digitize the reference signal (Ve3) for each group (SLi, VGi) of voltage values of the AC voltage, and to deliver a digital sample (Vi) representative of the amplitude of the reference signal (Ve3) in relation to the group of voltage values of the AC voltage in question.

9. Device according to Claim 8, wherein the detection circuit (MC) is configured to calculate the mean value (MVi) of the amplitude of the reference signal (Ve3) on the basis of a group of M digital samples (Vi) comprising the digital sample (Vi) representative of the current amplitude of the reference signal (Ve3) and M-1 digital samples (Vi) representative of the amplitude of the reference signal (Ve3) over previous cycles of the AC voltage in relation to the same group of voltage values of the AC voltage.

10. Device according to one of Claims 6 to 9, wherein the detection circuit is configured to generate binary words (Wj) of N bits (b0-b9) in which each bit is associated with a group (SLi, VGi) of voltage values of the AC voltage, and has a first value if a partial discharge signal has been detected in relation to the group of voltage values of the AC voltage in question and a second logic value if a partial discharge signal has not been detected in relation to the group of voltage values in question.

11. Method for detecting an insulation fault between a phase wire (P) and a neutral wire (N) in an electrical network carrying a low-voltage AC voltage (Vac), comprising steps of detecting partial discharge signals by analysing the voltage (Vac) or the current carried by the electrical network, **characterized in that** it comprises steps consisting in:

   - associating, with each detected partial discharge signal, a parameter (SLi, VGi) indicative of the position of the partial discharge signal on the curve of the AC voltage, and
   - searching for the existence, among a plurality of partial discharge signals detected during different variation cycles of the AC voltage, of at least one correlation (COR1, COR2, COR3) indicative of an insulation fault, taking into account the parameter (SLi, VGi) indicative of the position of the partial discharge signal on the curve of the AC voltage.

12. Method according to Claim 11, comprising steps consisting in:

- defining, as a parameter indicative of the position of a partial discharge signal on the curve of the AC voltage, groups (VGi) of voltage values of the AC voltage, and
- associating, with each detected discharge signal, a group (VGi) of voltage values of the AC voltage.

13. Method according to Claim 12, wherein each group (VGi) of voltage values of the AC voltage is identified by means of a time slot (SLi) representing a fraction of the period (T) of the AC voltage.

14. Method according to either of Claims 12 and 13, wherein an insulation fault is detected when a first number (N1) of partial discharge signals is detected during a first number (P1) of successive cycles of the AC voltage in relation to the same group (SLi, VGi) of voltage values of the AC voltage.

15. Method according to one of Claims 12 to 14, wherein an insulation fault is detected when:

- a first number (N1) of partial discharge signals is detected during a first number (P1) of successive cycles of the AC voltage in relation to a first group of voltage values of the AC voltage, and
- a second number (N2) of partial discharge signals is then detected during a second number (P2) of successive cycles of the AC voltage in relation to a second group of voltage values of the AC voltage comprising voltage values lower than the values of the first group.

DTC

N   P

Vac
CCT
L1   L2
C1   C2

ACT

Ve1
BPCT
Ve2
D1
EECT
C3   R1
Ve3

MC

Echantillonnage → Vi

Recherche de signaux PDS

ZCCT / PSCT
ZC
Vdd

Comptage CMP

Corrélation des signaux PDS

SA

SWi
SA
Vac

**Fig. 1**

Recherche de signaux PDS

E1   Détection du passage de Vac à 0 (ZC=1)

E2   CMP = 0 (remise à zéro compteur)
i=0 (créneau 0)

E3   Echantillonnage de Ve3 dans le créneau SLi,
obtention d'un échantillon Vi

E4   Calcul de la valeur moyenne MVi de Ve3 à partir
des M-1 échantillons précédents du créneau SLi
et du dernier échantillon Vi

E5   Calcul de l'écart type Ei des M échantillons de Vi

E6   Calcul d'un seuil de détection Si = MVi + K*Ei

E7   Si Vi > Si, alors bit bi=1, sinon bit bi=0

E8   CMP > D ? (D = durée d'un créneau)

Non          Oui

E9   i = 9 ?
(dernier créneau?)          Non

Oui

E11   Fournir un mot Wk = b0b1b2b3b4b5b6b7b8b9

E10   i=i+1
(créneau suivant)
CMP=0

Corrélation des signaux PDS
Recherche d'au moins une corrélation indicative d'un amorçage d'incendie

**Fig. 3**

Fig. 2A
Fig. 2B
Fig. 2C
Fig. 2D
Fig. 2E
Fig. 2F

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6172862 B
- US 20100073008 A
- US 20080309351 A
- US 5835321 A
- EP 0639879 A2
- JP 2005156452 A